(19) Europäisches Patentamt European Patent Office Office européen des brevets

(11) **EP 1 511 074 B1**

(12) **EUROPEAN PATENT SPECIFICATION**

(45) Date of publication and mention of the grant of the patent:
**28.01.2015 Bulletin 2015/05**

(51) Int Cl.:
**H01L 21/311** *(2006.01)*

(21) Application number: **04447059.9**

(22) Date of filing: **09.03.2004**

(54) **A method for selective removal of high-K material**

Verfahren zur selektiven Entfernung von Material mit hohem K

Procédé de retrait sélectif d'un matériau à constante K élevée

(84) Designated Contracting States:
**AT BE BG CH CY CZ DE DK EE ES FI FR GB GR HU IE IT LI LU MC NL PL PT RO SE SI SK TR**

(30) Priority: **01.08.2003 US 492020 P**

(43) Date of publication of application:
**02.03.2005 Bulletin 2005/09**

(73) Proprietor: **IMEC**
**3001 Leuven (BE)**

(72) Inventors:
• **Paraschiv, Vasile**
 **3000 Leuven (BE)**
• **Claes, Martine**
 **3060 Bertem (BE)**

(74) Representative: **Van Malderen, Joëlle et al**
 **pronovem - Office Van Malderen**
 **Avenue Josse Goffin 158**
 **1082 Bruxelles (BE)**

(56) References cited:
**EP-A- 0 968 979      US-A- 4 087 367**
**US-A- 5 271 797      US-A1- 2003 109 106**

• WATANABE D. ET AL.: "Selective wet etching for High-K material by organic solvent containing hydrofluoric acid" SEMICONDUCTOR PUR WATER AND CHEMICALS CONFERENCE, 2003 SPWCC, 17 February 2003 (2003-02-17), pages 117-130, XP008057967
• CHRISTENSON K.: "Selective wet etching of high-k materials" SOLID STATE TECHNOLOGY ONLINE, 3 July 2003 (2003-07-03), pages 1-7, XP002361400

EP 1 511 074 B1

## Description

## Field of the invention

The present invention concerns a new method of etching high-k material in a selective way towards $SiO_2$ and silicon layers.

## State of the art

Nowadays, one of the main microelectronics industry's demand is the increase of the circuit density. This means that devices have to be scaled to continuously smaller dimensions. The shrinking of the transistor feature size necessities the decrease of the gate dielectric layer thickness, that reaches his practical limit with the conventional gate dielectric material, like $SiO_2$ or nitrogen containing $SiO_2$. Because insulation layer thicknesses of less than 2 nm are expected in the future, alternative materials have to be considered. These materials characterized by a higher dielectric constant compared to $SiO_2$ (k=4), have been called high-k dielectric materials. Many dielectrics appear favorable in some areas but only few are promising with respect to all properties requirements.

Initially, some of the potential gate dielectric candidates, like $Ta_2O_5$, $SrTiO_3$ and $Al_2O_3$ have been inspired by the memory capacitor applications. It was however proved that the requirements for the transistor applications are much more selective than for the memory capacitors. Two key requirements are very important for transistor applications:

- an extremely high quality of the dielectric channel interface. This interface quality can only be approached if the high-k dielectrics are compatible with Si.
- the material must be able to withstand complementary metal-oxide semiconductor (CMOS) processing conditions while it is in contact with Si.

Besides these primary requirements, the integration criteria raise many questions. One of these questions is the selective removability of these almost chemically inert, and often relatively hard high-k materials over the source/drain areas,. So, both dry and wet removal hold big challenges with respect to silicon recess. The difficulties in removing the possible high-k candidates, mentioned in many publications, are enhanced by the fact that the process must be selective to the other layers that are included in the device.

In device applications, the high-k material is mostly thermally treated, making it very resistant to standard wet chemistries, and therefore difficult to remove selectively towards oxide layers. For as-deposited dielectric layers, often dilute HF solutions are used because of their relatively high etch rate. Much lower etch rates are observed for thermally treated layers. Nevertheless, the main constraint is not the etch rate but the poor selectivity towards $SiO_2$ and silicon layers.

Daikin reports (presented at the SPWC conference Feb 2003, California) on selective wet etching of high-k material by using an organic compound/25% HF mixture. The best selectivity reported is 1.7 for heat-treated MOCVD $HfO_2$ towards thermal oxide. The highest etch rate for $HfO_2$ is around 1 nm/min, also after annealing. The desired selectivity of 3:1 for thermally treated high-k towards oxide is not reached with their chemistry.

J. Barnett reports in the Proceedings of UCPSS 2002 (Solid State Phenomena, vol. 92, p11, 2003), on the wet etch enhancement of $HfO_2$ films by implant processing. However, the etch rate for a 20 nm $HfO_2$ layer with the hot phosphoric acid (155°C) used, is only 0.12nm/min. Besides this low etch rate, no results on selectivity towards other layers are included. Also, the last monolayer of $HfO_2$ seems not to be removable with hot phosphoric acid.

Mitsuhashi et al. report in US2003/0104706 on a method for wet-etching metal oxides. The surface of the metal oxide film is exposed to a plasma and the exposed metal oxide is then removed by a fluorine-containing solution. However, nothing is mentioned about selectivity towards SiO2 or polysilicon or silicon.

K. Saenger reports in the MRS Symposium Proceedings volume 745 (Novel Materials and Processes for advanced CMOS, Pennsylvania, p79, 2003) on a selective etching process for chemically inert high-k metal oxides. The method used is ion bombardment supplied by an oxygen plasma in a reactive ion etching tool. Oxygen treatments should be avoided in order not to alter high-k layer characteristics by oxygen diffusion.

K. Christenson reports in Proceedings of UCPSS 2002 (Solid State Phenomena, vol. 92, p 129, 2003) on the selective wet etching of high-k gate dielectrics. They only report on selectivity towards $SiO_2$ not towards silicon or polysilicon.

Document XP 002361400 discloses a method for selective removal of high-k materials such as $HfO_2$ or $ZrO_2$ towards $SiO_2$ involving subjecting the high-k materials to a damaging step followed by subjecting said high-k materials to a solution comprising HF and HCl.

Document XP 008057967 discloses a selective wet etching of $HfO_2$ films by organic solvent containing HF.

## Aims of the invention

The aim of the present invention is the disclosure of a new reliable method of etching high-k material with sufficient selectivity towards $SiO_2$ and silicon layers.

## Summary of the invention

According to the present invention, a method for selective removal of high-k material towards silicon, silicon oxide, or silicon nitride layers is disclosed, this method comprising the steps of:

- providing a high-k material on a semiconductor substrate, wherein said high-k material is selected from the group consisting of $ZrO_2$, $Al_2O_3$, $HfO_2$, $Zr_{1-x}Al_xO_y$, $HfSiO_x$, $HfAlO_x$, $HfSiO_xN$, x being an integer, y being an integer; and
- subjecting said high-k material to an etching solution comprising HF, an organic compound and an inorganic acid, wherein said inorganic acid is selected from the group consisting of HCl, $HNO_3$, $H_2SO_4$ and $H_3PO_4$, and said organic compound is selected from the group consisting of ethanol, isopropylalcohol and ethyleneglycol, wherein said method further comprises, prior to the step of subjecting said high-k material to said etching solution, the step of subjecting said high-k material to a damaging step which comprises a chemical damaging step or a physical damaging step.

In the present invention, the step of subjecting said high-k material to said solution is preceded by subjecting said high-k material to a damaging step.

Said method is of particular importance for removing the high-k material selectively towards silicon oxide and polysilicon. Furthermore, said method can remove the high-k material selective towards $Si_3N_4$. Silicon oxide, polysilicon or silicon nitride can be present on the same substrate as the high-k material. Silicon oxide can be thermal oxide as known by people skilled in the art.

Said high-k material is understood as being a material with a dielectric constant higher than the dielectric constant of silicon oxide. It is deposited using ALCVD or MOCVD. In a particular embodiment of the present invention, the dielectric constant of the high-k material is higher than 7, 10, higher than 15 or higher than 20. Said high-k material can be an oxide of Al, Zr, Hf or a combination thereof. In the present invention, said high-k material is selected from the group consisting of $ZrO_2$, $Al_2O_3$, $HfO_2$, $Zr_{1-x}Al_xO_y$, $HfSiO_x$, $HfAlO_x$, $HfSiO_xN$, x being an integer, y being an integer. Said high-k material can be in the amorphous phase or in the crystalline phase. For both phases, the high-k material can be as-deposited or can be treated at a predetermined temperature.

In a particular embodiment, the ratio of the etch rate of the high-k material towards the etch rate of silicon oxide (also called the selectivity towards silicon oxide) is at least 3:1, higher than 3:1, higher than 5:1. In another embodiment, the ratio of the etch rate of the high-k material towards the etch rate of polysilicon (also called the selectivity towards polysilicon) is at least 3:1, higher than 10:1, higher than 13:1. In another embodiment, the ratio of the etch rate of the high-k material towards the etch rate of silicon nitride (also called the selectivity towards silicon nitride) is at least 3:1, higher than 10:1, higher than 15:1 or higher than 20:1.

In an embodiment of the present invention, the concentration of HF is below 0.2 M and preferably below 0.1M. In particular, the concentration of HF is between 0.005 M and 0.1 M, between 0.04 and 0.06 M. Preferably, the concentration of HF is 0.05 M.

In the present invention, said inorganic acid is selected from the group consisting of HCl, $HNO_3$, $H_2SO_4$, $H_3PO_4$. In a preferred embodiment, the inorganic acid is HCl.

In another embodiment of the present invention, the concentration of the inorganic acid in the solution is below 50%, below 40 %, below 30 % and preferably between 10 % and 30%. The preferred value for the concentration of the inorganic acid is 20%. Variations of HCl concentration needs to results in a pH between -0.5 and 2. The inorganic acid is a commercially available diluted solution such as, but not limited hereto, 37 % HCl in water.

In an embodiment of this invention, said organic compound is selected such that selectivity is obtained towards other layers being present in i.e. transistor applications. In a particular embodiment, the concentration of the organic solvent is higher than 50 %, higher than 60 %, higher than 70 %. Preferably, the concentration of the organic solvent is between 50 % and 100 %, between 60 % and 90 % and preferably about 80%.

In another embodiment of the invention, said organic compound should be selected such that a good wetting of the high-k material is obtained. Preferably, the wettability of the organic compound for the high-k material is higher than the wettability for the silicon oxide. Wettability is being understood as having a contact angle below 5 degrees, below 4 degrees, below 3 degrees, below 2 degrees and preferably below 1 degree towards the high-k material.

In the present invention, said organic compound is an alcohol, with said alcohol being ethanol, isopropylalcohol or ethyleneglycol.

In another embodiment of the present invention, the temperature of said solution is higher than room temperature, higher than 20°C or higher than 35°C. The temperature of said solution is between 20 °C and 80°C, between 20°C and 70°C, between 30°C and 70°C, between 30°C and 60°C. In a preferred embodiment, the temperature of said solution is 40 °C.

In a particular and preferred embodiment of this invention, said solution comprises ethanol, HF and HCl. The amount of ethanol is 80 %, the concentration of HF is 0.05 M and the amount of HCl is 20%.

In a further embodiment said solution can be dispersed in the form of a vapor or a mist (finely dispersed droplets).

In another embodiment of the present invention, said solution does further comprise a surfactant (as known by a person skilled in the art). This allows to improve the wettability of the high-k material and to increase the selectivity further.

In this invention, said step of subjecting said thermally treated high-k material to a damaging step comprises a chemical damaging step or a physical damaging step. Chemical damaging being understood as altering the chemical composition of the high-k material. Physical damaging being understood as altering the physical properties of the high-k material. Said damaging step can comprise a plasma damaging (preferably with inert species) step or a step of damaging by ion implantation (preferably with neutral implants) at low energy.

In particular embodiments, the following results can be obtained:

- the highest selectivity for as-deposited and damaged-thermally treated $HfO_2$-based layers is obtained towards thermal oxide, i.e. infinite.
- a selectivity for as-deposited $HfO_2$-based layers of at least 14:1 towards polysilicon was obtained.
- a selectivity for damaged, thermally treated $HfO_2$-based layers of at least 250:1 towards polysilicon was obtained.
- a selectivity for damaged, thermally treated $HfO_2$-based layers of at least 20:1 was obtained towards $LPCV_D$ $Si_3N_4$.
- a selectivity of at least 9:1 was obtained in the case of HDP oxide.
- a selectivity of at least 5:1 was obtained in the case of DXZ oxide.
- a selectivity of at least 6:1 was obtained in the case of TEOS.
- a selectivity of at least 100:1 was obtained in the case of TaN and TiN.
- an etch rate of 5 nm/min in case of damaged, thermally treated $HfO_2$-based layers can be obtained at room temperature.

**Short description of the drawings**

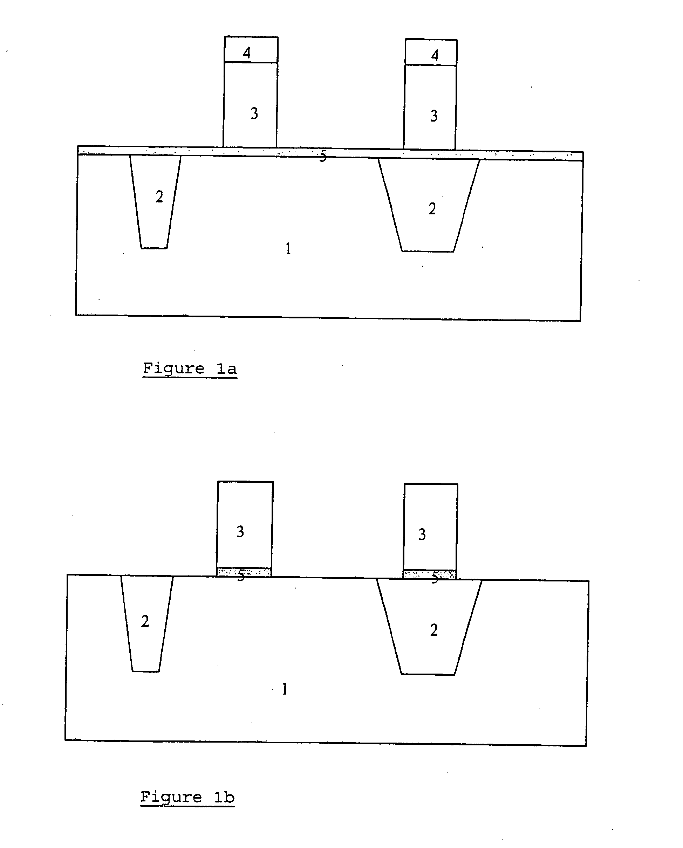

Figure 1a and 1b illustrate an application where the present invention is of particular importance.

**Detailed description of the invention**

Successful integration of high-k gate stacks requires attention to the optimization of the gate patterning. More specifically, a selective removal of high-k films over the source/drain areas is desired. Both dry and wet removal hold big challenges with respect to silicon recess. The present invention is of particular importance for this kind of application as depicted in figure 1a and 1b. Figure 1a shows a device consisting of a silicon substrate(1), an insulation structure(2), a gate polysilicon(3), a masking material(4) and a layer of high-k material(5). Figure 1b presents the result after treatment of this device according to the present invention. The high-k material is selectively removed resulting in an only underneath the polysilicon(3) remaining layer of high-k material(5).

The optimized etch chemistry (also called etch chemical or etchant) according to the present invention contains ethanol (or ethyleneglycol), HF and HCl. The etchant is optimized to get the highest selectivity towards thermal oxide and polysilicon (minimal etching). The chemical ratio and temperature are determined as such. The highest selectivity is achieved with a mixture of 80% ethanol, 0.05M HF (49%) and 20% HCl at mixing temperature (i.e. around 40°C). The active species of the etchant are fluorine based to accomplish etching, but an alcohol is added to achieve selectivity towards other exposed layers in transistor devices.

Improved selectivity for thermally treated (or crystalline material) $HfO_2$ is achieved by damaging the high-k layer by means of a plasma (inert gas) or ion implantation (low energies) prior to wet removal.

The etch rates are determined by measuring layer thickness before and after etching on a Plasmos SD2000 ellipsometer. Transmission Electron Microscopy analysis (Philips CM30, 300KV) is executed to verify Si recess and complete high-k removal on patterned polysilicon/$HfO_2$ gate electrodes. Rutherford Backscattering (RIBS) is used to determine complete high-k removal after the damaged etch procedure.

The method according to the present invention achieves higher selectivity towards $SiO_2$, providing at the same time a reasonable $HfO_2$ etch rate. The selective etch mixture consists of three components, i.e. an alcohol, HF and an inorganic acid, each of them playing a specific role in the etching mechanism. The HF component in the etchant mixture provides the active species for $HfO_2$ removal. In dilute HF (<1M), the following equilibriums are established:

$$HF \Leftrightarrow H^+ + F^-$$

$$HF + F^- \Leftrightarrow HF_2^-$$

$$2HF \Leftrightarrow H_2F_2$$

By varying the solution composition, one can select an etching mechanism by $HF_2^-$, $H_2F_2$ or a combination of both. $SiO_2$ is mainly etched by $HF_2^-$ species. In order to get high selectivity towards $SiO_2$ with HF, the etchant must restrain $HF_2^-$ species from being generated. One way to accomplish this is by adding an alcohol to the HF solution. An increase of the relative concentration of HF and $H_2F_2$ species is observed with the percentage of alcohol as a consequence of the lesser dissociation of the molecule. So, the concentration of $F^-$ and $HF_2^-$ species falls to low values for high alcohol concentrations and constant fluoride concentration. An important parameter is the dielectric constant of the alcohol or other polar solvents. It reflects the strength of electrostatic interactions of ions in the solvent. The lower the dielectric constant, the lower the oxide etch rate will be because of lesser dissociation of HF. The better behavior of solutions comprising alcohol may also be related to the surfactant properties of alcohols.

It is also possible to avoid the $HF_2^-$ formation, by adding an acid to an aqueous HF solution. This approach offers you the possibility to calculate the active species as a function of the pH. At low pH (< 2), HF is not dissociated. At intermediate pH, the HF is mainly transformed into $HF_2^-$ and at high pH (> 8), the mixture contains predominantly the $F^-$ ion. When adding HCl (pH < 1) to the etch solution, the equilibrium is shifted completely to the left, leaving only HF molecules in solution. When etching high-k material and thermal oxide at varying pH, it is observed that the etch rate of high-k material decreases significantly at pH 2.5 and higher, while the etch rate of thermal oxide is the highest between pH 2 and 3. This indicates that the high-k material is mainly etched by HF species, while the thermal oxide is mainly etched by $HF_2^-$ species.

With either only an HF/alcohol or an HF/HCl mixture, a good selectivity towards thermal oxide and polysilicon is reached. However to obtain the highest selectivity, each of the above-described components, i.e. HF, alcohol and acid are needed.

Different etch rates for different alcohols in combination with HF/HCl might be explained by either their wettability on each of the surfaces or by their dielectric constant. Preferably, the wettability for high-k material is higher than for thermal oxide. This means that the contact time of the solution on the high-k would be higher than on the oxide. In this way more high-k is etched compared to the oxide. The dielectric constant of the alcohol should be much lower than the dielectric constant of water

With an HF concentration in the range of 0.04-0.06M and preferably 0.05M, the highest selectivity for high-k towards both thox and polysilicon is obtained. With this concentration a reasonable amount of high-k is etched.

Increasing the alcohol concentration increases the selectivity towards thermal oxide and polysilicon. A selectivity of 14:1 towards polysilicon for as-deposited ALD $HfO_2$ and 250:1 for damaged, thermally treated HfO2 is reached with an 80% ethanol/0.05M HF/20% HCl mixture. When mixing those compounds, the temperature is around 40°C due to exothermal reaction. Heating up this mixture to 80°C did increase the high-k etch rate and brings higher selectivity towards oxide layers.

Implementing ethanol in a processing tool might lead to some safety issues because of its relatively low flash point (13°C), and boiling point (78°C). Therefore, also ethyleneglycol can be used, which has a flash point of 111°C and a boiling point of 198°C.

In device applications, the high-k material is mostly thermally treated, making it very resistant to standard wet chemistries, and therefore difficult to remove selectively towards oxide layers. From an integration point of view, a selectivity of at least 3:1 (preferably higher) for thermally treated high-k towards oxide is desirable. This is achieved with an appropriate pre-treatment of the $HfO_2$ layer after the thermal treatment. The applied pre-treatment is actually a damaging of the high-k material. This can be reached either by ion implantations at low energies or by ion bombardment supplied by an Ar plasma (inert gas).

Ion implantation can disrupt the crystalline structure (after thermal treatment of ALD $HfO_2$) to enhance wet chemical etching by either a physical damage or chemical mechanism. After implantation of thermally treated ALD HfO2, the etch rate increases for all implanted ions. The damaging effect is function of implant energy and dose. The etch rate can be influenced by altering the implantation dose and the implant energy. High-k material layers can be implanted with As, Ar, Ge, P, B, $BF_2$ or $GeF_2$ at implant energies of 2, 1, 2, 2, 0.5, 2 and 4 keV respectively. The $BF_2$ implantation dosage can be 1e15 or 2e15 at/cm$^2$.

Damaging is also reached by exposing the thermally treated $HfO_2$-based layers to an ion bombardment from an Ar plasma. In this step, the high-k layer is treated until around 1 nm of high-k is still left on the substrate. Afterwards, the damaged layer can be etched away with the optimal etch solution. In this way, the substrate is not damaged and Si recess can be avoided.

When high-k material is etched dry (with plasma), some polymers and high-k etch residues can still be present on the structures and substrate. The method according to the present invention can then be applied to remove selectively these post etch high-k residues/polymers.

## Claims

1. Method for selective removal of high-k material towards silicon, silicon oxide, or silicon nitride layers, comprising the steps of:

   - providing a high-k material on a semiconductor substrate, wherein said high-k material is selected from the group consisting of $ZrO_2$, $Al_2O_3$, $HfO_2$, $Zr_{1-x}Al_xO_y$, $HfSiO_x$, $HfAlO_x$, $HfSiO_xN$, x being an integer, y being an integer; and
   - subjecting said high-k material to an etching solution comprising HF, an organic compound and an inorganic acid, wherein said inorganic acid is selected from the group consisting of HCl, $HNO_3$, $H_2SO_4$ and $H_3PO_4$, and said organic compound is selected from the group consisting of ethanol, isopropylalcohol and ethyleneglycol, wherein said method further comprises, prior to the step of subjecting said high-k material to said etching solution, the step of subjecting said high-k material to a damaging step which comprises a chemical damaging step or a physical damaging step.

2. A method according to claim 1, **characterized in that** said high-k material has a dielectric constant higher than 7.

**3.** A method according to any of the claims 1 or 2, **characterized in that** the concentration of HF is below 0.2 M.

**4.** A method according to claim 3, **characterized in that** the concentration of HF is between 0.005 M and 0.1 M.

**5.** A method according to claim 4, **characterized in that** the concentration of HF is preferably about 0.05 M.

**6.** A method according to any of the claims 1 to 5, **characterized in that** the concentration of said inorganic acid in the solution is below 50%.

**7.** A method according to claim 6, **characterized in that** the concentration of said inorganic acid in the solution is between 10% and 30%.

**8.** A method according to claim 7, **characterized in that** the concentration of said inorganic acid in the solution is preferably about 20%

**9.** A method according to any of the claims 1 to 8, **characterized in that** the wettability of said organic compound is higher for said high-k material than for silicon oxide.

**10.** A method according to any of the claims 1 to 9, **characterized in that** the concentration of said organic compound is higher than 50%.

**11.** A method according to claim 10, **characterized in that** the concentration of said organic compound is between 60% and 90%.

**12.** A method according to claim 11, **characterized in that** the concentration of said organic compound is preferably about 80%.

**13.** A method according to any of the claims 1 to 12, **characterized in that** the temperature of said solution is between 20°C and 80°C.

**14.** A method according to claim 13, **characterized in that** the temperature of said solution is preferable around 40°C.

**15.** A method according to any of the claims 1 to 14, **characterized in that** said solution further comprises a surfactant.

**16.** A method according to any of the claims 1 to 15, **characterized in that** said solution has a pH between -0.5 and 2.

**17.** A method according to any of the claims 1 to 16, **characterized in that** said damaging step is a plasma damaging step performed with inert species.

**Patentansprüche**

**1.** Verfahren zum selektiven Entfernen von High-k-Material in Bezug auf Silicium-, Siliciumoxid- oder Siliciumnitridschichten, das die Schritte umfasst:

- Bereitstellen eines High-k-Materials auf einem Halbleitersubstrat, wobei das High-k-Material aus der Gruppe bestehend aus $ZrO_2$, $Al_2O_3$, $HfO_2$, $Zr_{1-x}Al_xO_y$, HfSiOx, $HfAlO_x$, $HfSiO_xN$ ausgewählt ist, wobei x eine ganze Zahl ist, wobei y eine ganze Zahl ist; und
- Aussetzen des High-k-Materials gegenüber einer Ätzlösung, die HF, eine organische Verbindung und eine anorganische Säure umfasst, wobei die anorganische Säure aus der Gruppe bestehend aus HCl, $HNO_3$, $H_2SO_4$ und $H_3PO_4$ ausgewählt ist, und wobei die organische Verbindung aus der Gruppe bestehend aus Ethanol, Isopropylalkohol und Ethylenglykol ausgewählt ist, wobei das Verfahren vor dem Schritt des Aussetzens des High-k-Materials gegenüber der Ätzlösung den Schritt des Unterziehens des High-k-Materials einem Schädigungsschritt umfasst, der einen chemischen Schädigungsschritt oder einen physischen Schädigungsschritt umfasst.

**2.** Verfahren nach Anspruch 1, **dadurch gekennzeichnet, dass** das High-k-Material eine dielektrische Konstante von mehr als 7 hat.

**3.** Verfahren nach einem der Ansprüche 1 oder 2, **dadurch gekennzeichnet, dass** die HF-Konzentration unter 0,2 M liegt.

**4.** Verfahren nach Anspruch 3, **dadurch gekennzeichnet, dass** die HF-Konzentration zwischen 0,005 M und 0,1 M liegt.

**5.** Verfahren nach Anspruch 4, **dadurch gekennzeichnet, dass** die HF-Konzentration vorzugsweise ungefähr 0,05 M beträgt.

**6.** Verfahren nach einem der Ansprüche 1 bis 5, **dadurch gekennzeichnet, dass** die Konzentration der anorganischen Säure in der Lösung weniger als 50 % beträgt.

**7.** Verfahren nach Anspruch 6, **dadurch gekennzeichnet, dass** die Konzentration der anorganischen Säure in der Lösung zwischen 10 % und 30 % liegt.

**8.** Verfahren nach Anspruch 7, **dadurch gekennzeichnet, dass** die Konzentration der anorganischen Säure in der Lösung vorzugsweise ungefähr 20 % beträgt.

**9.** Verfahren nach einem der Ansprüche 1 bis 8, **dadurch gekennzeichnet, dass** die Benetzbarkeit der organischen Verbindung für das High-k-Material höher als für Siliciumoxid ist.

**10.** Verfahren nach einem der Ansprüche 1 bis 9, **dadurch gekennzeichnet**, das die Konzentration der organischen Verbindung mehr als 50 % beträgt.

**11.** Verfahren nach Anspruch 10, **dadurch gekennzeichnet**, das die Konzentration der organischen Verbindung zwischen 60 % und 90 % liegt.

**12.** Verfahren nach Anspruch 11, **dadurch gekennzeichnet**, das die Konzentration der organischen Verbindung vorzugsweise ungefähr 80 % beträgt.

**13.** Verfahren nach einem der Ansprüche 1 bis 12, **dadurch gekennzeichnet, dass** die Temperatur der Lösung zwischen 20 °C und 80 °C liegt.

**14.** Verfahren nach Anspruch 13, **dadurch gekennzeichnet, dass** die Temperatur der Lösung vorzugsweise ungefähr 40 °C beträgt.

**15.** Verfahren nach einem der Ansprüche 1 bis 14, **dadurch gekennzeichnet, dass** die Lösung darüber hinaus ein Tensid umfasst.

**16.** Verfahren nach einem der Ansprüche 1 bis 15, **dadurch gekennzeichnet, dass** die Lösung einen pH-Wert zwischen -0,5 und 2 hat.

**17.** Verfahren nach einem der Ansprüche 1 bis 16, **dadurch gekennzeichnet, dass** der Schädigungsschritt ein mit einer inerten Spezies durchgeführter Plasmaschädigungsschritt ist.

**Revendications**

**1.** Procédé pour retirer sélectivement un matériau à constante k élevée dans des couches de silicium, d'oxyde de silicium, ou de nitrure de silicium, comprenant les étapes consistant à :

   - disposer un matériau à constante k élevée sur un substrat semi-conducteur, ledit matériau à constante k élevée étant choisi dans le groupe constitué par $ZrO_2$, $Al_2O_3$, $HfO_2$, $Zr_{1-x}Al_xO_y$, Hf-$SiO_x$, $HfAlO_x$, $HfSiO_xN$, où x est un entier et y est un entier ; et
   - soumettre ledit matériau à constante k élevée à une solution de gravure comprenant du HF, un composé organique et un acide inorganique, dans laquelle ledit acide inorganique est choisi dans le groupe constitué par HCl, $HNO_3$, $H_2SO_4$ et $H_3PO_4$, et ledit composé organique est choisi dans le groupe constitué par l'éthanol, l'alcool isopropylique et l'éthylèneglycol, ledit procédé comprenant en outre, avant l'étape consistant à soumettre ledit matériau à constante k élevée à ladite solution de gravure, l'étape consistant à soumettre ledit matériau à constante k élevée à une étape d'endommagement qui comprend une étape d'endommagement chimique ou une étape d'endommagement physique.

**2.** Procédé selon la revendication 1, **caractérisé en ce que** ledit matériau à constante k élevée a une constante diélectrique supérieure à 7.

**3.** Procédé selon l'une quelconque des revendications 1 ou 2, **caractérisé en ce que** la concentration de HF est inférieure à 0,2 M.

**4.** Procédé selon la revendication 3, **caractérisé en ce que** la concentration de HF est comprise entre 0,005 M et 0,1 M.

**5.** Procédé selon la revendication 4, **caractérisé en ce que** la concentration de HF est de préférence d'environ 0,05 M.

**6.** Procédé selon l'une quelconque des revendications 1 à 5, **caractérisé en ce que** la concentration dudit acide inorganique dans la solution est inférieure à 50 %.

**7.** Procédé selon la revendication 6, **caractérisé en ce que** la concentration dudit acide inorganique dans la solution est comprise entre 10 % et 30 %.

**8.** Procédé selon la revendication 7, **caractérisé en ce que** la concentration dudit acide inorganique dans la solution est de préférence d'environ 20 %.

**9.** Procédé selon l'une quelconque des revendications 1 à 8, **caractérisé en ce que** la mouillabilité dudit composé organique est plus élevée pour le matériau à constante k élevée que pour l'oxyde de silicium.

**10.** Procédé selon l'une quelconque des revendications 1 à 9, **caractérisé en ce que** la concentration dudit composé organique est supérieure à 50 %.

**11.** Procédé selon la revendication 10, **caractérisé en ce que** la concentration dudit composé organique est comprise entre 60 % et 90 %.

**12.** Procédé selon la revendication 11, **caractérisé en**

**ce que** la concentration dudit composé organique est de préférence d'environ 80 %.

**13.** Procédé selon l'une quelconque des revendications 1 à 12, **caractérisé en ce que** la température de ladite solution est comprise entre 20°C et 80°C.

**14.** Procédé selon la revendication 13, **caractérisé en ce que** la température de ladite solution est de préférence d'environ 40°C.

**15.** Procédé selon l'une quelconque des revendications 1 à 14, **caractérisé en ce que** ladite solution comprend en outre un tensioactif.

**16.** Procédé selon l'une quelconque des revendications 1 à 15, **caractérisé en ce que** ladite solution a un pH compris entre -0,5 et 2.

**17.** Procédé selon l'une quelconque des revendications 1 à 16, **caractérisé en ce que** ladite étape d'endommagement est une étape d'endommagement au plasma effectuée avec des espèces inertes.

Figure 1a

Figure 1b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030104706 A

**Non-patent literature cited in the description**

- **J. BARNETT.** *Proceedings of UCPSS 2002 (Solid State Phenomena,* 2003, vol. 92, 11
- **K. SAENGER.** *MRS Symposium Proceedings volume 745 (Novel Materials and Processes for advanced CMOS,* 2003, vol. 745, 79
- **K. CHRISTENSON.** *Proceedings of UCPSS 2002 (Solid State Phenomena,* 2003, vol. 92, 129